(19) Europäisches Patentamt
European Patent Office
Office européen des brevets

(11) EP 2 693 504 A1

(12) **EUROPEAN PATENT APPLICATION**
published in accordance with Art. 153(4) EPC

(43) Date of publication:
**05.02.2014 Bulletin 2014/06**

(21) Application number: **12764013.4**

(22) Date of filing: **29.03.2012**

(51) Int Cl.:
***H01L 51/42*** *(2006.01)*

(86) International application number:
**PCT/JP2012/002175**

(87) International publication number:
**WO 2012/132447 (04.10.2012 Gazette 2012/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.03.2011 JP 2011079772**

(71) Applicant: **Idemitsu Kosan Co., Ltd**
**Tokyo 100-8321 (JP)**

(72) Inventors:
- **MAEDA, Ryoji**
  **Sodegaura-shi**
  **Chiba 299-0293 (JP)**
- **TOKAILIN, Hiroshi**
  **Sodegaura-shi**
  **Chiba 299-0293 (JP)**

(74) Representative: **Gille Hrabal**
**Patentanwälte**
**Brucknerstrasse 20**
**40593 Düsseldorf (DE)**

(54) **ORGANIC THIN-FILM SOLAR CELL AND ORGANIC THIN-FILM SOLAR CELL MODULE**

(57) An organic thin film solar cell including a cathode, a charge-generating layer and an anode being sequentially stacked, which further comprises a charge-transporting layer having a carrier mobility of $1 \times 10^{-9}$ $cm^2/Vs$ or more at an electric field intensity of 0 V/cm between the cathode and the charge-generating layer and/or between the anode and the charge-generating layer.

FIG.1

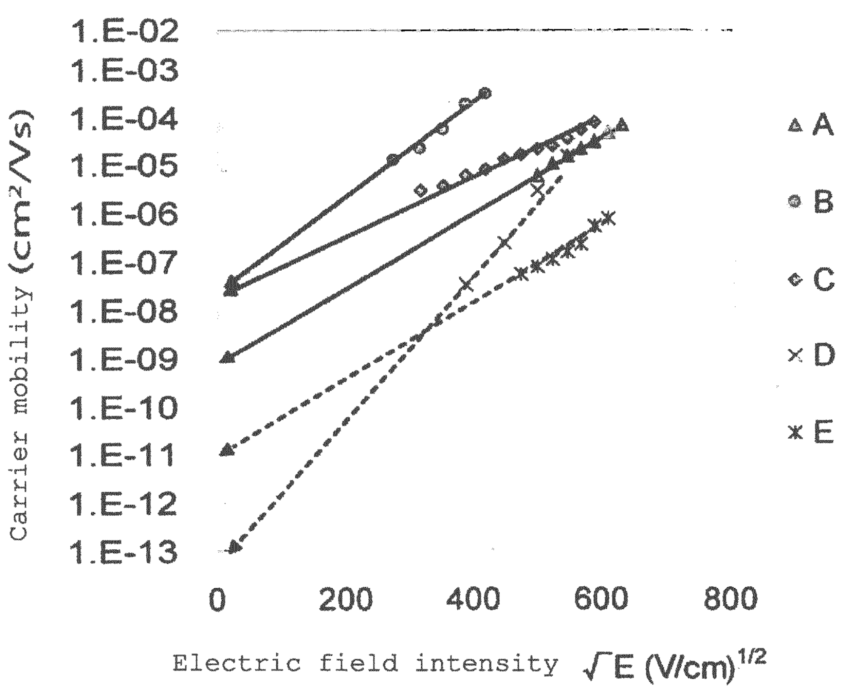


EP 2 693 504 A1

## Description

Technical Field

The invention relates to an organic thin-film solar cell and a module using the organic thin film solar cell.

Background Art

Backed by the shortage of fossil fuel or global warming, a solar cell has recently attracted attention as the source of clean energy, and research and development on a solar cell has been aggressively made.

Heretofore, silicon-based solar cells using monocrystalline Si, polycrystalline Si, amorphous Si, or the like have been put into practical use. Since the problem such as expensiveness or the shortage or the like of raw material Si has come up to the surface, there has been an increasing demand for a next-generation solar cell. Under such circumstances, an organic solar cell has attracted significant attention as a next-generation solar cell since it is inexpensive and is free from fear of shortage of raw materials.

An organic solar cell is basically composed of an n layer which transfers electrons and a p layer which transfers holes, the n layer and the p layer being provided between the electrodes and is roughly divided into two according to the material constituting each layer.

A solar cell in which, a layer obtained by subjecting a sensitizing dye such as a ruthenium dye to monomolecular adsorption on the surface of an inorganic semiconductor such as titania is used as the n layer, and an electrolyte solution is used as the p layer, is called as a dye-sensitized solar cell (so-called a Graetzel cell). Researches on the dye-sensitized solar cell have been energetically conducted since 1991 in view of its high photoelectric conversion efficiency (hereinafter often abbreviated simply as "conversion efficiency"). However, it has defects that leakage occurs after the use for a long period of time due to the use of a solution, or the like. In order to overcome such defects, researches to obtain an all solid-type dye-sensitized solar cell by solidifying an electrolyte solution have been made recently. However, the technology of allowing an organic substance to be perfused to fine pores of porous titania is very difficult, and therefore, a cell which exhibits a high conversion efficiency with a good reproducibility has not yet been completed.

On the other hand, an organic thin film solar cell in which both of the n layer and the p layer are formed from organic thin films does not have defects such as leakage of a solution because it is an all solid-type cell. In addition, it can be easily fabricated, uses no ruthenium which is a rare metal, and has other advantages. Therefore, such an organic thin film solar cell has attracted attention and has been energetically studied.

As for organic thin film solar cells, studies have been made in the early stage on a monolayer film formed of a merocyanine dye or the like in a charge-generation layer. It was found that the conversion efficiency increases by using a multilayer film of a p layer/n layer in a charge-generation layer, and thereafter, such a multilayer film has been mainly employed. Thereafter, it was found that insertion of an i layer (a mixture layer of a p-material that transports holes and an n-material that transports electrons) between the p layer and the n layer results in improvement in the conversion efficiency. Subsequently, it was found that the conversion efficiency is further improved by employing a tandem cell structure in which cells each formed of a p/i/n layer are stacked serially.

On the other hand, in an organic thin film solar cell using a polymer material, studies have been made on the so-called bulkhetero structure in which a conductive polymer is used as the p material and a $C_{60}$ derivative is used as the n material. These materials are mixed and the resulting mixture is subjected to a heat treatment to induce the separation of micro layers of the p material and the n material, whereby the hetero interface is increased to improve the conversion efficiency.

As mentioned above, in an organic thin film solar cell, the conversion efficiency was improved by optimizing the cell structure and the morphology of the p material and the n material. However, as compared with inorganic solar cells represented by silicon or the like, improvement in photoelectric conversion efficiency has become the most important subject in order to put an organic thin film solar cell into practice.

In general, the operation process of an organic thin film solar cell is essentially composed of (1) absorption of light and generation of excitons, (2) diffusion of excitons, (3) separation of electric charges, (4) movement of electric charges and (5) generation of an electromotive force. In order to improve the efficiency of an organic thin film solar cell, it is important to simplify these elementary processes.

As a technology of efficiently taking out charges generated in the charge-generating layers such as the p layer, the n layer and the i layer to improve photoelectric conversion efficiency, in Patent Document 1, use of an organic semiconductor having a charge mobility of 0.005 ($cm^2/V{\cdot}s$) or more measured by an FET method is proposed, for example.

Patent Document 2 proposes a device provided with an energy transfer layer which aims at improving photoelectric conversion efficiency by transferring excited energy to the charge-generating layer.

Patent Document 3 proposes a device in which a hole-blocking layer or an electron-blocking layer is disposed between an electrode and an organic charge generating layer, thereby to improve photoelectric conversion efficiency.

However, actually, none of these technologies shows the guidance of designing a device which realizes a high conversion efficiency.

Related Art Documents

Patent Documents

Patent Document 1: WO2007/015503
Patent Document 2: JP-A-2007-134444
Patent Document 3: JP-A-2007-88033

Summary of the invention

An object of the invention is to provide an organic thin film solar cell having a high conversion efficiency.
As can be understood from the above-mentioned elemental operation processes of an organic thin film solar cell, charge transportation is the important factor for improving the photoelectric conversion efficiency. Here, the inventors think, when considering carrier mobility in respect of charge transportation in an organic thin film solar cell, it is important to consider the carrier mobility at a low field intensity at which an organic thin film solar cell actually operates.
In Patent Document 1, a carrier mobility measured by an FET method is considered. The carrier mobility measured by this method is a characteristic value showing transportation capacity of charges moving between the source electrode and the drain electrode (i.e. in a direction parallel to the substrate) on the organic semiconductor layer formed on the substrate. Further, in the measurement, the carrier mobility is calculated in the state where electric field intensity, that is, a voltage applied to between the electrodes, is high. Therefore, it is impossible to directly compare this carrier mobility with the carrier mobility in the direction perpendicular to the substrate in the organic compound layer disposed between a pair of electrodes. As a result, even if a compound having a high carrier mobility measured by the FET method (i.e. having a high carrier mobility in the state where the electric field intensity is high) is used, there are cases where the conversion efficiency of an organic thin film solar cell is not significantly improved.
As mentioned above, in the present circumstances, the device design noting the carrier mobility of each compound in the state where an electric field is not applied (i.e. a state in which an organic thin film solar cell operates), that is, the device design in the state where the electric field intensity is zero, has not been conducted.
The inventors made intensive studies based on the above-mentioned finding. As a result, the inventors have found that, as the carrier mobility, not the charge transportation in the direction parallel to the substrate as in the case of the FET method, but the charge transportation in the direction perpendicular to the substrate in the structure of an organic solar cell, in which the photoelectric conversion layer is disposed between the electrodes, is important, and the inventors have also found that an organic thin film solar cell having a high conversion efficiency can be obtained by providing a charge-transporting layer between the electrodes and the charge-generating layer, and by using a compound having a high carrier mobility in the state where the electric field intensity is zero (0 V/cm) in the charge-transporting layer. The invention has been made based on this finding.
According to the invention, the following organic thin film solar cell or the like are provided.

1. An organic thin film solar cell comprising a cathode, a charge-generating layer and an anode being sequentially stacked, which further comprises a charge-transporting layer having a carrier mobility of $1 \times 10^{-9}$ $cm^2/Vs$ or more at an electric field intensity of 0 V/cm between the cathode and the charge-generating layer and/or between the anode and the charge-generating layer.
2. The organic thin film solar cell according to 1, wherein the charge-transporting layer has a function of blocking the transportation of charges which are reverse to the charges to be primarily transported by the charge-transporting layer.
3. The organic thin film solar cell according to 1 or 2, wherein the charge-generating layer comprises a complex.
4. The organic thin film solar cell according to 3, wherein the complex is a phthalocyanine complex.
5. The organic thin film solar cell according to 3, wherein the complex is a naphthalocyanine complex.
6. The organic thin film solar cell according to any of 1 to 5, wherein the charge-generating layer comprises fullerene or a fullerene derivative.
7. The organic thin film solar cell according to any of 1 to 6, wherein the charge-transporting layer between the cathode and the charge-generating layer has an ionization potential of 5.2 to 5.8 eV.
8. A module for an organic thin film solar cell which uses the organic thin film solar cell according to any of 1 to 7.

According to the invention, an organic thin film solar cell having a high conversion efficiency can be obtained.
The invention enables selection of a compound having a high charge-transporting capability at an electric field intensity which is suited to the actual operation circumstances of an organic thin film solar cell, and greatly contributes to the design of a highly efficient organic thin film solar cell.

Brief Description of the Drawings

FIG 1 is a view showing the relationship between the square root (√E) of the electric field intensity (E) and the carrier mobility (μ); and
FIG. 2 is an emission spectrum or an absorption spectrum of the compound in Examples.

Mode for Carrying out the Invention

The organic thin film solar cell of the invention has a cathode, a charge-(carrier) generation layer and an anode serially being stacked. The characteristic feature of the invention is that it comprises a charge-transporting layer, between a cathode and a carrier-generating layer, and/or between an anode and a charge-generating layer, having a carrier mobility at an electric field intensity of 0 V/cm (hereinafter often referred to as the carrier mobility at $E_o$) of $1 \times 10^{-9}$ $cm^2/Vs$ or more.
In the invention, the carrier mobility of the charge-transporting layer is measured by Impedance Spectroscopy: IS). For the measurement by the IS method, an impedance analyzer (e.g. 4294A manufactured by Agilent Technologies, Inc.) is used. The measurement apparatus is not limited to this, and other usable apparatus includes a Frequency Response Analyzer (Solartron 1260 Impedance Analyzer manufactured by Solartron Analytical) and a 1296 Dielectric Measurement Interface (manufactured by Solartron Analytical) or the like. In the measurement, for an applied voltage of a prescribed direct current, an alternate current of 50 mV (frequency range: 100 to 1 MHz) is superimposed.
In an impedance analyzer, a minute sinusoidal voltage signal [$V = V_oe \times p\ (i\omega t)$] is applied to a sample to be measured (a compound constituting the charge-transporting layer). From the current amplitude and phase difference of the response current signal [$I = I_oe \times p\{i\ (\omega t + \varphi)\}$], impedance (Z = V/I) and capacitance of a sample can be measured.
Admittance and susceptance are obtained from impedance, capacitance and the equivalent circuit of the sample, and then the carrier mobility is calculated.
In the analysis of the IS method, generally, the equivalent circuit is determined by a method in which, using the frequency of the applied voltage signal as a parameter, the equivalent circuit of the device is assumed from the orbit of the impedance displayed on the complex plane (Cole-Cole plot), and the orbit of the Cole-Cole plot calculated from the equivalent circuit is allowed to agree with the measured data.
It is known that, in the IS method, in a single charge injection model in which either electrons or holes is injected, the equivalent circuit becomes an R-C (resistance-capacitance) parallel circuit. Specifically, in the analysis of the carrier mobility, the formulas of current represented by the following (1) to (3), the Poisson's formula and the current continuity formula are used.

$$J(x,t) = q\rho(x,t)\mu E(x,t) + \varepsilon \frac{\partial E(x,t)}{\partial t} \qquad (1)$$

$$\frac{\partial E(x,t)}{\partial x} = \frac{q\rho(x,t)}{\varepsilon} \qquad (2)$$

$$\frac{q\rho(x,t)}{\partial t} = \frac{1}{q}\frac{\partial J(x,t)}{\partial x} \qquad (3)$$

In the above formula, q is the amount of charges, μ is mobility and e is a dielectric constant.
In the analysis of minute signals (minute current signals and minute voltage signals), the current density J, the electric field E and the carrier density ρ are expressed by the following formula (4):

$$\begin{aligned} J(t) &= J_{dc} + J_1(t) \\ E(x,t) &= E_{dc}(x) + E_1(x,t) \qquad (4) \\ \rho(x,t) &= \rho_{dc}(x) + \rho_1(x,t) \end{aligned}$$

If the above-mentioned formula is approximated to the primary minor term, the minute current signal is expressed by the following formula (5):

$$J_1(t) = q\mu\rho_{dc}(x)E_1(x,t) + \varepsilon\mu E_{dc}(x)\frac{\partial E_1(x,t)}{\partial x} + \varepsilon\frac{\partial E_1(x,t)}{\partial t} \qquad (5)$$

By subjecting the formula (5) to Fourier transformation, the following formula (6) can be given.

$$J_1(\omega) = q\mu\rho_{dc}(x)E_1(x,\omega) + \varepsilon\mu E_{dc}(x)\frac{\partial E_1(x,\omega)}{\partial x} + i\omega\varepsilon E_1(x,\omega) \qquad (6)$$

If only direct current components are considered, the formulas (7) and (8) can be obtained.

$$E_{dc}(x) = \frac{2\sqrt{d}}{t_t\mu}x^{\frac{1}{2}} \qquad (7)$$

$$\rho_{dc}(x) = \frac{\varepsilon\sqrt{d}}{qt_t\mu}x^{-\frac{1}{2}} \qquad (8)$$

In the formula, d is a distance (film thickness).

By substituting the formulas (7) and (8) into the formula (6), the following formula (9) can be obtained.

$$J_1(\omega) = \frac{\varepsilon\sqrt{d}}{t_t}x^{-\frac{1}{2}}E_1(x,\omega) + \frac{2\varepsilon\sqrt{d}}{t_t}x^{\frac{1}{2}}\frac{\partial E_1(x,\omega)}{\partial x} + i\omega\varepsilon E_1(x,\omega) \qquad (9)$$

By solving the formula (9) for $E_1(x, w)$, the following formula (10) can be obtained.

$$E_1(x,\omega) = \frac{J_1(\omega)}{i\omega\varepsilon}\left[1 - \frac{\sqrt{d}}{i\omega t_t}x^{\frac{1}{2}}\left\{1 - \exp\left(\frac{-i\omega t_t}{\sqrt{d}}x^{\frac{1}{2}}\right)\right\}\right] \qquad (10)$$

From the above, the minute voltage signal is represented by the following formula (11):

$$V_1(\omega) = \int_0^d E_1(x,\omega)dx = \frac{J_1(\omega)}{i\omega\varepsilon}\left[d - \frac{2d}{i\omega t_t} - 2d\left\{\frac{1}{\omega t_t}\right\}^2\{1 - \exp(-i\omega t_t)\}\right] \qquad (11)$$

If assumption is made that $\theta$ is $\omega t_t$ in the formula (11), since admittance for the minute signal is $Y_1=J_1/V_1$. the following formula (12) can be obtained.

$$Y_1(\theta) = \frac{\varepsilon}{t_t d}\left[\frac{\theta^3}{2i\{1-\exp(-i\theta)\}+2\theta-i\theta^2}\right] \quad (12)$$

From the formula (12), conductance $G_1$ and susceptance $B_1$ are expressed by the following formulas (14) and (15):

$$Y_1 = G_1 + jB_1 \quad (13)$$

$$G_1 = \frac{g\theta^3}{6}\frac{\theta-\sin\theta}{(\theta-\sin\theta)^2+\left(\frac{\theta^2}{2}+\cos\theta-1\right)^2} \quad (14)$$

$$B_1 = \omega C_1 = \frac{g\theta^3}{6}\frac{\frac{\theta^2}{2}+\cos\theta-1}{(\theta-\sin\theta)^2+\left(\frac{\theta^2}{2}+\cos\theta-1\right)^2} \quad (15)$$

$$g = \frac{9\varepsilon\mu V_0}{4d^3}, \qquad \theta = \omega t_t$$

From the above formula, it can be understood that, in the case of a single charge injection model in which either electrons or holes are injected, the equivalent circuit becomes an R-C parallel circuit.

By the above calculation, admittance is obtained from impedance and capacitance obtained from the measurement of a sample, and then conductance as the real part and susceptance as the imaginary part are obtained.

The carrier mobility can be obtained from a maximum value shown in the changed amount ($\Delta$B) by the transit-time effect of susceptance B which is the imaginary part of admittance.

Here, an explanation is made on the transit-time effect. Due to the frequency properties of capacitance, capacitance decreases from the high-frequency region to the low-frequency region. The reason therefor is that, the space charge by carriers injected by the minute voltage signal cannot follow completely the minute AC voltage, causing a phase delay in the current. In the high-frequency region, injected carriers cannot follow the AC electric field, and hence, they cannot reach the opposite electrode in a 1/2 period. As a result, a geometrical capacity is measured. This phenomenon is referred to as the transit-time effect.

In general, a method for evaluating the carrier mobility from the maximum value of susceptance by the transit-time effect is reported as a (-$\Delta$B method) (see PHYSICAL REVIEW B 63 125328 (2001) or the like).

In a single charge injection model in which only either of electrons or holes are injected, in the frequency characteristics represented by the following formula (16), in the lowest frequency side, the frequency and the transit-time effect at which -$\Delta$B becomes the maximum, there is a relationship represented by the following formula (17):

$$-\Delta B = \omega(C_1 - C_{geo}) \quad (16)$$

$$t_t \approx 0.72 f_{\max}^{-1} \quad (17)$$

In the above formula, $C_1$ is capacitance, $C_{geo}$ is geometrical capacity and f is peak frequency.

Therefore, based on the measurement results of impedance, required admittance or susceptance can be calculated, and by using the -$\Delta$B method, transit-time, i.e. carrier mobility, can be calculated.

The electric field intensity (E) can be obtained from the film thickness of a sample (d: cm) by E=V/d on the

assumption that the voltage (V) is uniformly applied in the film thickness direction.

By the above-mentioned method, the carrier mobility is obtained for a plurality of electric field intensities. Based on the results, the relationship formula between the electric field intensity and the carrier mobility is induced. From this relationship formula, the carrier mobility at $E_0$ (electric field intensity is 0 V/cm) is calculated. Normally, relative to the square root ($\sqrt{E}$) of the electric field intensity E, the carrier mobility changes linearly (see FIG. 1 explained in Examples).

In the invention, it is preferred that a plurality of carrier mobility be obtained in the electric field intensity of $1 \times 10^4$ V/cm to $1 \times 10^7$ V/cm, and that the carrier mobility at an electric field intensity of 0 V/cm be calculated form the results.

From the measurement results of the carrier mobility at $E_0$, it has been understood that, if the carrier mobility is high in the state where a strong external voltage such as $1 \times 10^4$V/cm to $1 \times 10^7$V/cm is applied, the carrier mobility at $E_0$ may be low. That is, from the results obtained by the conventional measurement of carrier mobility, a material having a high carrier mobility in the region in which an electric field intensity at a single point is high is not necessarily suitable for use in an organic thin film solar cell. Therefore, as in Patent Document 1, selecting a material based on the charge transportation in the direction parallel to the substrate by the FET method and based on the carrier mobility measured in the region in which the electric field intensity is high is not necessarily suitable for an organic thin film solar cell. That is, if the carrier mobility is low at $E_0$, this material is not useful in an organic thin film solar cell.

In the invention, the carrier mobility at $E_0$ of the charge-transporting layer is $1 \times 10^{-9}$ $cm^2$/Vs or more. By this carrier mobility, the conversion efficiency of the organic thin film solar cell can be improved. It is more preferred that the carrier mobility at $E_0$ of the charge-transporting layer be $1 \times 10^{-8}$ $cm^2$/Vs or more. No specific restrictions are imposed on the upper limit of the carrier mobility. Actually, the upper limit is around $1 \times 10^2$ $cm^2$/Vs.

As for the charge-transporting layer of the invention, it is particularly preferred that the carrier mobility in the state where a high electric field intensity is applied be high, and a change in carrier mobility relative to the electric field intensity be small. It is also particularly preferred that the carrier mobility at $E_0$ be $1 \times 10^{-9}$ $cm^2$/Vs or more.

As the method for measuring the carrier mobility of the charge-transporting layer, in addition to the above-mentioned IS method, a Time-of-flight (TOF) method and a Dark injection (DI) transient method and an FET method can be mentioned. Also, a method in which carrier mobility is measured from the I-V characteristics of Space-charge-limited-current (SCLC) can be given. However, in the TOF method and the DI method, the carrier transit time is measured at a good S/N ratio. Therefore, while the film thickness of the organic layer of the actual organic thin film solar cell is about several tens nm, a sample having a significantly large thickness, for example several μm to several tens μm, is required. This value should not be compared, since it is too different from the actual film thickness of an organic thin film solar cell. In the FET method, the carrier mobility relating to charge transportation in the direction parallel to the substrate is shown. This value is a characteristic value which cannot be directly compared with the carrier mobility in the direction vertical to the substrate in the charge-generating layer disposed between a pair of electrodes, which is required in an organic thin film solar cell. The SCLC method has a defect that the dependency of the carrier mobility on the electric field cannot be obtained. Therefore, the carrier mobility obtained by these measurement methods cannot be used in the invention.

As for the compound usable in the charge-transporting layer of the invention, no specific restrictions are imposed as long as the carrier mobility at $E_0$ is $1 \times 10^{-9}$ ($cm^2$/Vs) or more. When the charge-transporting layer is formed by the deposition method, a polymer or a high-molecular compound is not preferable. Specific examples of the compound are shown below.

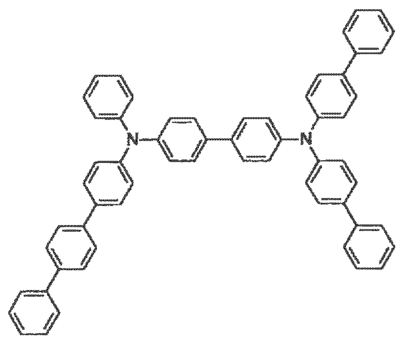

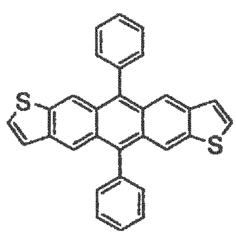

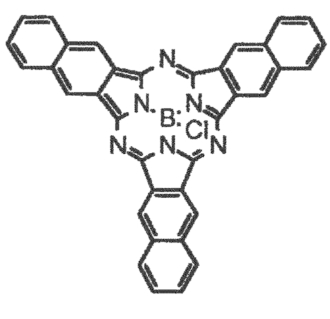

In the invention, it is preferred that the charge-transporting layer have a function of blocking the transport of charges which are charged reversely to the charges to be primarily transported by the charge-transporting layer. Specifically, in order to move the holes generated in the charge-generating layer efficiently to the cathode, it is preferred that the charge-transporting layer (hole-transporting layer) between the cathode and the charge-generating layer be configured such that transfer of electrons to the cathode is prevented. In order to move the electrons generated in the charge-generating layer efficiently to the anode, it is preferred that the charge-transporting layer (electron-transporting

layer) between the anode and the charge-generating layer to be configured such that transfer of holes to the anode is prevented. If it does not have a function of blocking the transportation of charges, on the cathode side, for example, due to the occurrence of transfer of holes and electrons to the cathode side in the electron-transporting layer (hole-transporting layer) disposed between the cathode and the charge-generating layer, deactivation by the recombination of holes and electrodes occurs. Similarly, it is assumed that, in the anode side, in the charge-transporting layer (electron-transporting layer) between the anode and the charge-generating layer, due to the occurrence of transfer of electrons and holes to the anode side, deactivation occurs by the recombination of holes and electrons. Therefore, since the charge-transporting layer has a function of blocking the transportation of charges reverse to the primarily-transported charges, deactivation caused by recombination of holes and electrons can be suppressed, whereby charges can be taken out efficiently to each electrode.

In order to block transportation of electrons which are charged reversely to holes in the hole-transporting layer, it suffices that the affinity level ($Af_H$) of the hole-transporting layer be smaller than the affinity level ($Af_G$) of the charge-generating layer. It is preferred that the difference between the two affinity levels ($\Delta Af=Af_G-Af_H$) be 0.3 eV or more, with 0.5 eV or more being particularly preferable.

Similarly, in order to block transportation of holes which are charged reversely to electrons in the electron-transporting layer, it suffices that the ionization potential ($Ip_E$) of the electron-transporting layer be larger than the ionization potential ($Ip_G$) of the charge-generating layer.

The ionization potential ($Ip_H$) of the charge-transporting layer between the cathode and the charge-generating layer, i.e. a hole-transporting layer, is preferably 5.2 to 5.8 eV. By this ionization potential, an energy gap with the affinity level of the n material of the charge-generating layer becomes sufficiently large and it becomes possible to allow the open end voltage (Voc) of the organic thin film solar cell to be high. As a result, the conversion efficiency of an organic thin film solar cell can be improved.

Moreover, it is preferable to use a compound that has a large energy gap (difference between ionization potential and affinity level) for a hole-transporting layer. As a result, light outside the battery can be introduced to the charge-generating layer without being absorbed. It is preferred that the energy gap be 2.2 eV or more.

In the organic thin film solar cell of the invention, no specific restrictions are imposed on the constitution elements other than the above-mentioned charge-transporting layer, and elements known in this technical field can be used.

Examples of layer configuration of the organic thin film solar cell are given below. The substrate is omitted. The substrate may be provided on one or both sides of the cathode side and the anode side.

(1) Cathode/Charge-transporting layer/i layer (mixture layer of a p material and an n material)/Anode
(2) Cathode/i layer/Charge-transporting layer/Anode
(3) Cathode/Charge-transporting layer/i layer/Charge-transporting layer/Anode
(4) Cathode/Charge-transporting layer/p layer/n layer/Anode
(5) Cathode/p layer/n layer/Charge-transporting layer/Anode
(6) Cathode/Charge-transporting layer/p layer/n layer/Charge-transporting layer/Anode
(7) Cathode/Charge-transporting layer/p layer/n layer/Buffer layer/Anode
(8) Cathode/Buffer layer/Charge-transporting layer/p layer/n layer/Buffer layer/Anode
(9) Cathode/Buffer layer/Charge-transporting layer/p layer/i layer/n layer/Buffer layer/Anode
(10) Cathode/Buffer layer/Charge-transporting layer/p layer/n layer/Buffer layer/Intermediate electrode/Buffer layer/Charge-transporting layer/p layer/n layer/Buffer layer/Anode
(11) Cathode/Buffer layer/Charge-transporting layer/p layer/i layer/n layer/Buffer layer/Intermediate electrode/Buffer layer/Charge-transporting layer/p layer/i layer/n layer/Buffer layer/Anode

In the invention, a layer before the charge-generating layer relative to the light introduction direction (a buffer layer, a charge-transporting layer or the like, for example) may transfer excited energy obtained by light absorption to the charge-generating layer. Further, as for part of light, the wavelength thereof is changed such that the amount of light in the light absorption region in the charge-generating layer is increased. That is, energy may be transferred from the buffer layer or the charge-transporting layer to the charge-generating layer. As a result, the charge-generating layer can be effectively utilize light in the non-sensitive region, and as a result, the conversion efficiency of the organic thin film solar cell is improved.

In the above-mentioned energy transfer, it is important that normalized emission spectrum of a layer which transfers energy is overlapped with the normalized absorption spectrum of a layer which receives energy from the layer which transfers energy.

In order to allow favorable energy transfer to occur, it is preferred that the normalized emission spectrum in a layer which transfers energy be overlapped with the normalized emission spectrum in a layer which receives energy from the energy transfer layer in 10% or more in terms of area. Here, normalization means normalization conducted

based on the maximum peak intensity.

By satisfying the above-mentioned conditions, excitons generated by light absorption in a layer which transfers energy are moved to adjacent layers by the Foerster's energy transfer.

Hereinbelow, examples of each constitutional element of the organic thin film solar cell will be explained.

1. Cathode and anode

No particular restrictions are imposed on the material for the cathode and the anode, and a known conductive material can be used. For example, as the cathode material, a metal such as tin-doped indium oxide (ITO), fluorine-doped tin oxide (FTO), gold (Au), osmium (Os) and palladium (Pd) can be used. As the anode material, metals such as silver (Ag), aluminum (Al), indium (In), calcium (Ca), platinum (Pt) and lithium (Li); a binary metal system such as Mg: Ag, Mg:In or Al:Li can be used, and further, materials exemplified as the cathode material can be given.

To obtain high efficient photoelectric conversion properties, it is desired that at least one surface of the organic thin film solar cell preferably have sufficient transparency in the solar light spectrum. The transparent electrode can be formed of a known conductive material by deposition, sputtering or the like such that the predetermined light transmittance is ensured. It is preferred that the light transmittance of the electrode on the light-receiving surface be 10% or more. In a preferable configuration in which a pair of electrodes is provided, one of the electrodes contains a metal having a large work function and the other contains a metal having a small work function.

2. Charge-generating layer

The charge-generating layer is a layer which absorbs light and generates charges (holes and electrons) and is any of a layer formed of an electron-donating p material (p layer), a layer formed of an electron-accepting n material (n layer) and a layer formed of a mixture layer (i layer) of a p material and an n material. By using an i layer singly or in combination with these layers, a charge-generating layer is obtained.

No specific restrictions are imposed on the p material. However, it is preferable to use a compound having a function as a hole acceptor. A material having a high hole mobility is preferable.

For example, amine compounds represented by N,N'-bis(3-tolyl)-N,N'-diphenylbenzidine (mTPD), N,N'-dinaphthyl-N,N'-diphenylbenzidine (NPD) and 4,4',4''-tris(phenyl-3-tolylamino)triphenylamine (MTDATA); phthalocyanines such as phthalocyanine (Pc), copper phthalocyanine (CuPc), zinc phthalocyanine (ZnPc), titanylphthalocyanine (TiOPc) and boron phthalocyanine (SubPc); and porphyrin complexes represented by naphthalocyanine complexes, benzoporphine (BP), octaethylporphyrin (OEP), platinum octaethylporphyrin (PtOEP) and zinc tetraphenylporphyrin (ZnTPP) can be given.

As polymer compounds that require coating process by a solution, main chain-type conjugated polymers such as methoxyethylhexyloxyphenylenevinylene (MEHPPV) and polyhexylthiophene (P3HT) and cyclopentadithiophene-benzothiadiazole (PCPDTBT), and side chain-type polymers represented by polyvinyl carbazole can be given.

Of the above-mentioned p materials, a complex is preferable in the invention. In particular, a phthalocyanine complex or a naphthalocyanine complex is preferable.

As is known from phthalocyanine blue which is one of representative dyes, a phthalocyanine complex has a strong skeleton and has excellent weather resistance and heat resistance. When used in the charge-generating layer, a phthalocyanine complex is capable of generating charges by excellent light absorption. A phthalocyanine complex is a material which is excellent in durability.

No specific restrictions are imposed on the central metal of a complex. The central metal may be a metal atom or an oxometal atom such as magnesium (Mg), zinc (Zn), iron (Fe), nickel (Ni), cobalt (Co), tin (Sn), lead (Pb), copper (Cu), silicon (Si), palladium (Pd), titanium (Ti), titanium oxide (TiO), vanadium (V), or an oxometal atom and vanadyl (VO).

As the naphthalocyanine complex, the following compounds are preferable.

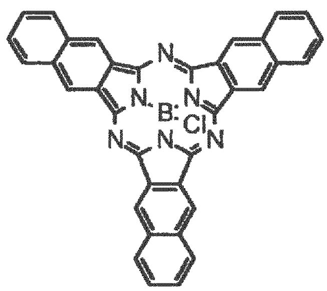

As the preferable p material, in addition to the phthalocyanine complex and the naphthalocyanine complex as mentioned above, a π-conjugated compound, a squarylium dye compound, a Bodipy-based compound and a dipyrin-based compound can be given.

As the π-conjugated compound as the p material, the following compound can be given, for example.

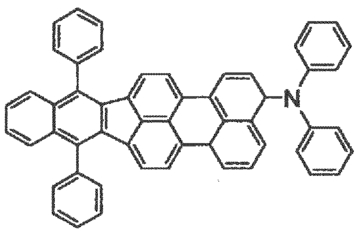

As the squarylium dye compound as the p material, the following compound can be given, for example.

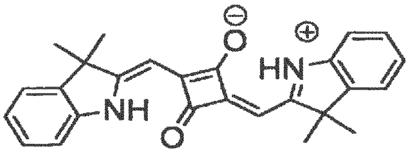

As the Bodipy-based compound as the p material, the following compound can be given, for example.

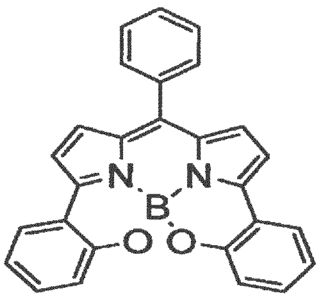

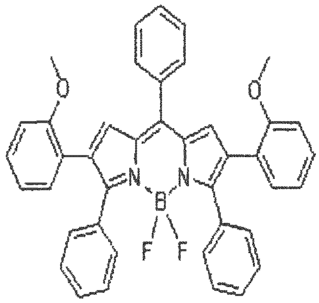

As the dipyrin-based compound as the p material, the following compound can be given, for example.

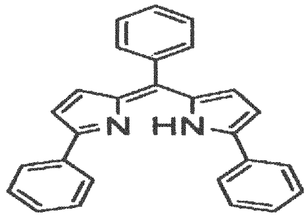

It is preferred that the ionization potential ($Ip_H$) of the p material be 5.2 to 5.8 eV. Due to such an ionization potential), the energy gap with the affinity level of the n material of the charge-generating layer becomes sufficiently large, and it becomes possible to increase the open-circuit voltage (Voc), leading to an increase in conversion efficiency of the organic thin film solar cell.

Although no specific restrictions are imposed on the n material, it is preferable to use a compound having a hole-donating function and having a high electron mobility.

For example, as organic compounds, fullerene derivatives such as $C_{60}$ and $C_{70}$, carbon nanotube, perylene derivatives, polycyclic quinones and quinacridone can be given, and as polymers, CN-poly(phenylene-vinylene), MEH-CN-PPV, polymers having a -CN group or a $CF_3$ group and poly(fluorene) derivatives can be given. Preferred are materials having are materials having a small affinity level (electron affinity). Use of such a material having a small affinity leval in combination for the n layer can lead to a sufficient open-circuit voltage.

In the invention, fullerene or a fullerene derivative is preferable in respect of conversion efficiency.

As inorganic compounds, an inorganic semiconductor compound having n-type characteristics can be given. Specific examples include doped semiconductors and compound semiconductors such as n-Si, GaAs, CdS, PbS, CdSe, InP, $Nb_2O_5$, $WO_3$ and $Fe_2O_3$; and titanium oxides such as titanium dioxide ($TiO_2$), titanium monoxide (TiO) and dititanium trioxide ($Ti_2O_3$); and conductive oxides such as zinc oxide (ZnO) and tin oxide ($SnO_2$). The above-mentioned inorganic semiconductor compounds having an n-type characteristic may be used alone or in combination of two or more. In respect of conversion efficiency, titanium oxide is preferably used, with titanium dioxide being particularly preferable.

3. Buffer layer

In general, an organic thin film solar cell has a small total film thickness, and hence, the cathode and the anode often short-circuit so that a yield in fabrication of the cells may decrease. It is preferred that such short-circuit be prevented by stacking a buffer layer in contact with the electrode. In order to take the generated current outside efficiently, a buffer layer is preferably provided.

As for materials preferable for the buffer layer, as a low-molecular compound, aromatic cyclic acid anhydrides represented by NTCDA as shown below can be given, and as a polymer compound, known conductive polymers represented by poly(3,4-ethylenedioxy)thiophene:polystyrene sulfonate (PEDOT:PSS) and polyaniline:camphor sulfonic acid (PANI:CSA) can be given.

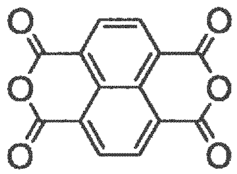

NTCDA

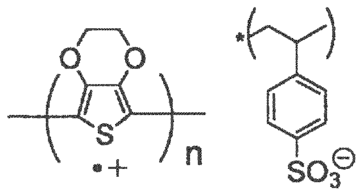

PEDOT : PSS

It is possible to allow the buffer layer to serve as a layer that prevents excitons from being diffused to the electrode and deactivated. Inserting a buffer layer as the exciton-blocking layer is effective for improving efficiency. An exciton-blocking layer may be inserted on either of the cathode side or the anode side, or may be inserted on the both sides.

In this case, as the preferable material for use in the exciton-blocking layer, a material for a hole-blocking layer, a material for an electron-blocking layer or the like, which are known in the application of an organic EL device, can be given. As a material which is preferable for use in the hole-blocking layer, a compound having a sufficiently large ionization potential can be given. As a material which is preferable for use in the electron-blocking layer, a compound having a sufficiently small electron affinity can be given. As specific examples, bathocuproin (BCP), bathophenanthroline (BPhen) or the like, which are known materials in the application of an organic EL device, can be given as the material for the hole-blocking layer on the anode side.

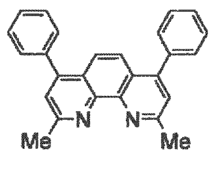

BCP

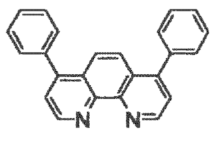

BPhen

Further, in the buffer layer, an inorganic semiconductor compound exemplified above as the n material can be used. As the p-type inorganic semiconductor compound, CdTe, p-Si, SiC, GaAs, $WO_3$ or the like can be given.

4. Substrate

As the material for the substrate, materials having mechanical strength, thermal strength and transparency are preferable. Examples of the substrate include glass substrates and transparent resin films.

The transparent resin films include films made of polyethylene, ethylene-vinyl acetate copolymer, ethylene-vinyl alcohol copolymer, polypropylene, polystyrene, poly(methyl methacrylate), polyvinylchloride, polyvinylalcohol, polyvinylbutyral, nylon, polyether ether ketone, polysulfone, polyether sulfone, tetrafluoroethylene-perfluoroalkylvinyl ether copolymer, polyvinylfluoride, tetrafluoroethylene-ethylene copolymer, tetrafluoroethylene-hexafluoropropylene copolymer, polychlorotrifluoroethylene, polyvinylidene fluoride, polyester, polycarbonate, polyurethane, polyimide, polyetherimide, polyimide and polypropylene.

5. Intermediate electrode

In a stacked organic thin film solar cell (tandem cell), by forming an electron-hole recombination zone by provision of an intermediate electrode, it is possible to separate photoelectric conversion units of the stacked device. This layer serves to prevent formation of inverted hetero junction between the n layer of the front photoelectric conversion unit (front cell) and the p layer of the back photoelectric conversion unit (back cell). The layer between each photoelectric conversion unit provides a zone in which electrons injected from the front photoelectric conversion unit and holes injected from the back photoelectric conversion unit are recombined. Efficient recombination of electrons injected from the front photoelectric conversion unit and holes injected from the back photoelectric conversion unit is required when photo-induced current is attempted to be generated in a stacked device.

No particular restrictions are imposed on a material for forming an electron-hole recombination zone by the intermediate electrode. The material for forming the upper electrode and the lower electrode as mentioned above can be used. Preferably, an electron-hole recombination zone by the intermediate electrode contains a thin metal layer. It is required that the metal layer be sufficiently thin and semi-transparent so that light can reach the back (a plurality of) photoelectric conversion unit

For this purpose, the thickness of the metal layer is preferably smaller than about 20A. It is particular preferred if the metal film be about 5A-thick. It is considered that these extremely thin metal films (~5Å) are not continuous films, but rather composed of independent metal nano particles. Surprisingly, although this significantly thin metal layer is not continuous, this is still effective as an electron-hole recombination layer. Examples of preferable metals used in this layer include Ag, Li, LiF, Al, Ti and Sn. Of these metals, Ag is particularly preferable. It may be an alloy with $MoO_3$, for example.

Each layer of the organic thin film solar cell of the invention can be formed by dry film-forming methods such as vacuum vapor deposition, sputtering, plasma coating, and ion plating, and wet film-forming methods such as spin coating, dip coating, casting, roll coating, flow coating and inkjet Any of the above-mentioned film forming processes or the combination thereof can be used. However, since the organic thin film is affected by moisture and oxygen, it is more preferred that the film forming process be unified.

The film thickness of each layer is not particularly limited, but the film can be made into an appropriate film thickness. It is generally known that the exciton diffusion length of an organic thin film is short. If the film thickness is too thick, excitons may be deactivated before they reach the hetero interface, so that photoelectric conversion efficiency becomes low. On the other hand, if the film thickness is too thin, generation of pinholes or the like may occur. As a result, the sufficient diode properties cannot be obtained, resulting in lowering of the conversion efficiency. The appropriate film thickness of each layer is usually in a range of 1 nm to 10 μm, and further preferably in a range of 3 nm to 0.2 μm.

In the case of employing the dry film-forming method, known resistance heating methods are preferable. In the case of forming a mixture layer, a film-forming method in which co-deposition is conducted using plural evaporation sources is preferable, for example. Further preferred is to control the substrate temperature during film-formation.

In the case of employing the wet film-forming method, a material for forming each layer is dissolved or dispersed in an appropriate solvent to prepare an organic solution, and a thin film is formed from the solution. The solvent can be arbitrarily selected. The usable solvent includes halogenated hydrocarbon-based solvents such as dichloromethane, dichloroethane, chloroform, carbon tetrachloride, tetrachloroethane, trichloroethane, chlorobenzene, dichlorobenzene and chlorotoluene; ether-based solvents such as dibutyl ether, tetrahydrofuran, dioxane and anisole; alcohol-based solvents such as methanol, ethanol, propanol, butanol, pentanol, hexanol, cyclohexanol, methyl cellosolve, ethyl cellosolve and ethylene glycol; hydrocarbon-based solvents such as benzene, toluene, xylene, ethylbenzene, hexane, octane, decane and tetralin; and ester-based solvents such as ethyl acetate, butyl acetate and amyl acetate. Of these, the hydrocarbon-based solvents and the ether solvents are preferable. These solvents may be used alone or in a mixture of two or more. Usable solvents are not limited thereto. Further, in order to remove the solvent in the thin film formed by the wet film-forming method, heating at an appropriate temperature is included.

In the invention, appropriate resins or additives may be used in any of the organic thin film layers in the organic thin film solar cell in order to improve film-forming properties or for the prevention of generating pinholes of the film, or the like. Usable resins include insulating resins such as polystyrene, polycarbonate, polyarylate, polyester, polyamide, polyurethane, polysulfone, poly(methyl methacrylate), poly(methyl acrylate) and cellulose, and copolymers thereof, photo-conductive resins such as poly-N-vinylcarbazole and polysilane; and conductive resins such as polythiophene and polypyrrole.

The additives include an antioxidant, an ultraviolet absorbent and a plasticizer.

Due to its high conversion efficiency, the organic thin film solar cell of the invention is preferable for use in a cellular phone and mobile electronic apparatuses, which utilize intrinsic properties of an organic solar cell such as light-weightness and flexibility, and is also preferable as an organic thin film solar cell module which can be used as an emergency power source which is compact and easy to store.

EXAMPLES

[Measurement of mobility of carrier used in charge-transporting layer]

As for the following compounds A to E used in the Examples and the Comparative Examples of the invention, the carrier mobility at an electric field intensity of 0 was measured by the following procedures.

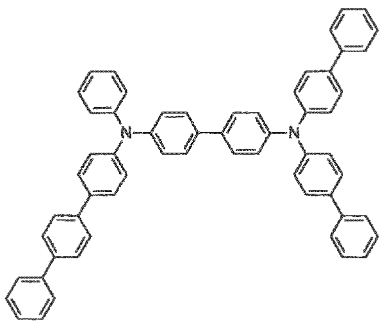

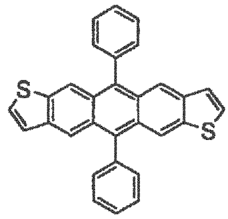

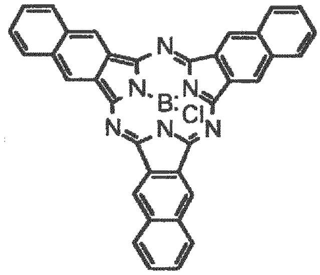

A B C

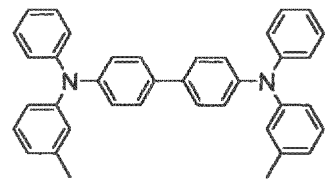

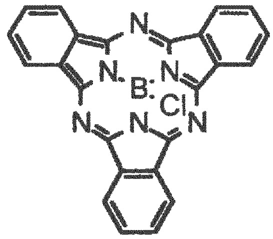

D E

(1) Preparation of a sample

A glass substrate of 25 mm by 75 mm by 0.7 mm thick with an ITO transparent electrode was subjected to ultrasonic cleaning with isopropyl alcohol for 5 minutes, and cleaned with ultraviolet rays and ozone for 30 minutes. The substrate with lines of a transparent electrode thus cleaned was mounted on a substrate holder in a vacuum deposition apparatus. Compound A was formed into a 100 nm-thick film by the resistance heating deposition at a deposition rate of 1Å/s so as to cover the surface of the substrate on which the transparent electrode lines were formed as a low electrode. Subsequently, on this film, metal Al was formed into an 80 nm-thick film by the deposition at a deposition as an opposite electrode, whereby a single-charge device was fabricated. The area of the device was 0.5 $cm^2$.

(2) Measurement of carrier mobility

By using an impedance analyzer (Agilent-4294A), impedance and capacitance of each compound were measured. By obtaining admittance from these values, conductance as the real part and susceptance as the imaginary part were obtained. From the maximum value of susceptance by the transit-time effect, the carrier mobility was calculated (-ΔB method).

The voltage applied to the sample fabricated in (1) above (single-charge device) was obtained by superimposing an alternate current of 50 mV on a direct current voltage (-1 to + 6V). The frequency range was 100 Hz to 1 MHz.

The carrier mobility ($\mu$) against the root square ($\sqrt{E}$) of the electric field intensity (E) is shown in FIG. 1. In FIG. 1, "1.E-XX" means "$1.0 \times 10^{-xx}$".

As shown in FIG. 1, the carrier mobility was plotted against the root square ($\sqrt{E}$) of the electric field intensity, and a line was fitted to the points by using the least-square method. The carrier mobility at $E_0$ was obtained by extrapolation

to the zero electric field along the fitted line. As the measurement range, at 250 to 700 $(V/cm)^{1/2}$ of the root square ($\sqrt{E}$) of the electric field intensity, a voltage was applied stepwise at an interval of 0.25 (V), and the resulting 4 or more measurement points were subjected to the least-squared fitting, whereby the carrier mobility at $E_0$ was obtained.

As is apparent from FIG. 1, even though the carrier mobility in the state where a high electric field intensity was applied was about the same, the carrier mobility at which the electric field intensity became zero varied largely according to the compound.

The carrier mobility, the ionization potential and the affinity level at $E_0$ of each compound are shown in Table 1.

The ionization potential was measured by means of a photoelectron spectroscopy in air (AC-3, manufactured by Riken Keiki Co., Ltd.). Specifically, the ionization potential was measured by a method in which a material was irradiated with light, and the amount of electrons generated at this time by separation of charges was measured.

The affinity level was measured by a method in which an energy gap was obtained from the absorption end of the absorption spectrum of the deposited film, and calculated from the measurement values of the ionization potential and the energy gap.

TABLE 1

| Compound | Carrier mobility at $E_0$ ($cm^2/Vs$) | Ionization potential (eV) | Affinity level (eV) |
|---|---|---|---|
| A | $1 \times 10^{-9}$ | 5.4 | 2.5 |
| B | $6 \times 10^{-8}$ | 5.4 | 3.0 |
| C | $6 \times 10^{-8}$ | 5.4 | 3.8 |
| D | $6 \times 10^{-14}$ | 5.5 | 2.4 |
| E | $1 \times 10^{-11}$ | 5.7 | 3.7 |

[Fabrication of an organic thin film solar cell]

Example 1

A glass substrate of 25 mm by 75 mm by 0.7 mm thick with an ITO transparent electrode was subjected to ultrasonic cleaning with isopropyl alcohol for 5 minutes, and cleaned with ultraviolet rays and ozone for 30 minutes. The substrate with lines of a transparent electrode thus cleaned was mounted on a substrate holder in a vacuum deposition apparatus. The compound A was formed into a 10 nm-thick film by the resistance heating deposition at a deposition rate of 1Å/s so as to cover the surface of the substrate on which the transparent electrode, a lower electrode (cathode) lines were formed. The layer of the compound A functions as the charge-transporting layer.

Subsequently, a 10 nm-thick layer of the compound E was formed on the layer of the compound A by the resistance heating deposition at a deposition rate of 1Å/s. The compound E was a phthalocyanine complex composed of boron and a cyclic compound in which three isoindolines were bonded by a nitrogen atom. The layer of the compound E functions as the charge-generating layer (p layer).

Subsequently, on the layer of the compound E, a layer of the following C60 was formed by the resistance heating deposition in a film thickness of 40 nm (ionization potential: 6.3 eV, affinity level: 4.4 eV) at a deposition speed of 1 Å/s. The layer of C60 functions as the charge-generating layer (n layer).

Further, on the layer of C60, bathocuproin (BCP) was formed in a film thickness of 10 nm by the resistance heating deposition at a deposition speed of 1Å/s. The BCP layer functions as the buffer layer.

Lastly, as the opposite electrode (anode), metal Al was continuously deposited in a film thickness of 80 nm, whereby an organic thin film solar cell was fabricated. The area of the device was 0.5 $cm^2$.

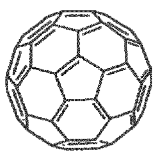

$C_{60}$

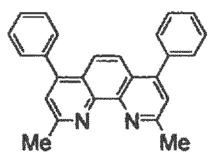

(Me is a methyl group)

BCP

The I-V characteristics were determined for the organic thin film solar cell thus fabricated under a condition of

AM 1.5 (light intensity ($P_{in}$): 100 mW/cm$^2$). From the results, the open-circuit voltage (Voc), the short-circuit current density (Jsc) and the fill factor (FF) were obtained, and the photoelectric conversion efficiency ($\eta$) was calculated by the following equation. The results are shown in Table 2.

The conversion efficiency was calculated by the following equation:

$$\eta\ (\%) = \frac{Voc \times Jsc \times FF}{Pin} \times 100$$

A large value of Voc, Jsc and FF for the same $P_{in}$ means an excellent conversion efficiency.

Example 2

An organic thin film solar cell was fabricated and evaluated in the same manner as in Example 1, except that the compound E was changed to the compound C. The compound C was a naphthalocyanine complex formed of boron and a cyclic compound in which 3 benzoisoindolines were bonded by a nitrogen atom. The results are shown in Table 2.

Example 3

An organic thin film solar cell was fabricated and evaluated in the same manner as in Example 2, except that the compound A was changed to the compound B. The results are shown in Table 2.

The compound B was a compound having thienyl-fused rings at both terminals relative to the anthracene skeleton. The compound B is an acene compound which is linear. As compared with a pentacene in which benzene rings are fused, by fusing by a thiophene skeleton, the compound becomes resistant to oxidation, and the ionization potential is increased, whereby an increase in open-circuit voltage Voc becomes possible.

Example 4

An organic thin film solar cell was fabricated and evaluated in the same manner as in Example 3, except that $C_{60}$ was changed to the following $C_{70}$. The results are shown in Table 2.

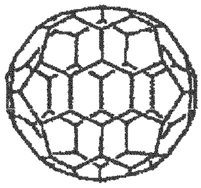

$C_{70}$

Comparative Example 1

An organic thin film solar cell was fabricated and evaluated in the same manner as in Example 1, except that the film thickness of the compound A was changed to 40 nm and the layer of the compound E was not formed. The results are shown in Table 2. In the device of Comparative Example 1, the compound A constituted a charge-generating layer.

Comparative Example 2

An organic thin film solar cell was fabricated and evaluated in the same manner as in Example 3, except that the compound B was changed to the compound D. The results are shown in Table 2.

Example 5

An organic thin film solar cell was fabricated and evaluated in the same manner as in Example 2, except that the compound F was used instead of the compound C. The results are shown in Table 2.

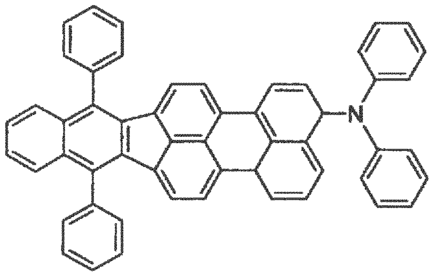

**Compound F**

Comparative Example 3

An organic thin film solar cell was fabricated and evaluated in the same manner as in Comparative Example 2, except that the compound C was changed to the compound F. The results are shown in Table 2.

Example 6

An organic thin film solar cell was fabricated and evaluated in the same manner as in Example 2, except that the compound C was changed to the compound G. The results are shown in Table 2.

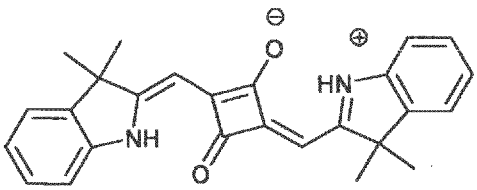

**Compound G**

Comparative Example 4

An organic thin film solar cell was fabricated and evaluated in the same manner as in Comparative Example 2, except that the compound C was changed to the compound G. The results are shown in Table 2.

Example 7

An organic thin film solar cell was fabricated and evaluated in the same manner as in Example 2, except that the compound C was changed to the compound H. The results are shown in Table 2.

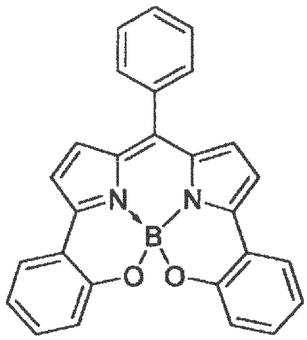

**Compound H**

Comparative Example 5

An organic thin film solar cell was fabricated and evaluated in the same manner as in Comparative Example 2, except that the compound C was changed to the compound H. The results are shown in Table 2.

Example 8

An organic thin film solar cell was fabricated and evaluated in the same manner as in Example 2, except that

the compound C was changed to the compound I. The results are shown in Table 2.

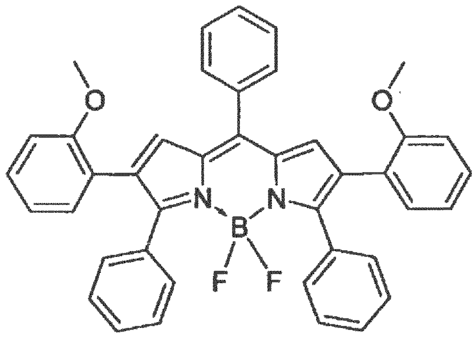

Compound I

Comparative Example 6

An organic thin film solar cell was fabricated and evaluated in the same manner as in Comparative Example 2, except that the compound C was changed to the compound I. The results are shown in Table 2.

Example 9

An organic thin film solar cell was fabricated and evaluated in the same manner as in Example 2, except that the compound C was changed to the compound J. The results are shown in Table 2.

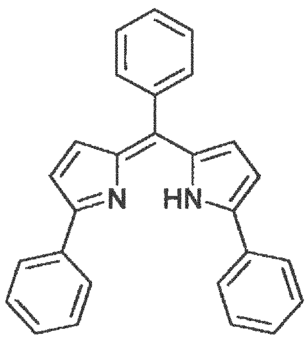

Compound J

Comparative Example 7

An organic thin film solar cell was fabricated and evaluated in the same manner as in Comparative Example 2, except that the compound C was changed to the compound J. The results are shown in Table 2.

TABLE 2

| | Compound for charge-transporting layer (HTL) | Compound for charge-generating layer | | Thickness of HTL (nm) | Thickness of p layer (nm) | Thickness of n layer (nm) | Voc (V) | Jsc (mA/cm$^2$) | FF (-) | η(%) |
|---|---|---|---|---|---|---|---|---|---|---|
| | | P layer | n layer | | | | | | | |
| Example 1 | A | E | $C_{60}$ | 10 | 10 | 40 | 1.12 | 4.82 | 0.39 | 2.09 |
| Example 2 | A | C | $C_{60}$ | 10 | 10 | 40 | 0.83 | 8.09 | 0.65 | 4.35 |
| Example 3 | B | C | $C_{60}$ | 10 | 10 | 40 | 0.83 | 8.40 | 0.65 | 4.51 |
| Example 4 | B | C | $C_{70}$ | 10 | 10 | 40 | 0.87 | 11.14 | 0.52 | 5.00 |
| Com. Ex. 1 | - | A | $C_{60}$ | 0 | 40 | 40 | 0.88 | 1.72 | 0.44 | 0.66 |
| Com. Ex. 2 | D | C | $C_{60}$ | 10 | 10 | 40 | 0.86 | 6.70 | 0.30 | 1.76 |
| Example 5 | A | F | $C_{60}$ | 10 | 10 | 40 | 0.77 | 3.93 | 0.54 | 1.63 |
| Example 6 | A | G | $C_{60}$ | 10 | 10 | 40 | 0.56 | 2.20 | 0.43 | 0.53 |
| Example 7 | A | H | $C_{60}$ | 10 | 10 | 40 | 1.01 | 5.75 | 0.53 | 3.10 |
| Example 8 | A | I | $C_{60}$ | 10 | 10 | 40 | 0.97 | 3.45 | 0.42 | 1.40 |
| Example 9 | A | J | $C_{60}$ | 10 | 10 | 40 | 0.91 | 5.16 | 0.59 | 2.77 |
| Com. Ex. 3 | D | F | $C_{60}$ | 10 | 10 | 40 | 0.77 | 3.71 | 0.51 | 1.45 |
| Com. Ex. 4 | D | G | $C_{60}$ | 10 | 10 | 40 | 0.51 | 1.96 | 0.28 | 0.28 |
| Com. Ex. 5 | D | H | $C_{60}$ | 10 | 10 | 40 | 0.98 | 4.80 | 0.42 | 1.99 |
| Com. Ex. 6 | D | I | $C_{60}$ | 10 | 10 | 40 | 0.97 | 2.48 | 0.27 | 0.65 |
| Com. Ex. 7 | D | J | $C_{60}$ | 10 | 10 | 40 | 0.86 | 2.90 | 0.30 | 0.75 |

Voc: Open circuit voltage Jsc: short-circuit current density FF: Fill factor η: Conversion efficiency

From the results shown in Table 2, it can be confirmed that, as in the case of the organic thin film solar cells of Examples of the invention in which a charge-transporting layer and a charge-generating layer are provided and the charge-transporting layer satisfies the requirements of the invention, the conversion efficiency of the organic solar cell significantly increases.

The emission spectrum of each of the compounds A, B and D and the absorption spectrum of the compound C are shown in FIG. 2. In FIG. 2, if the emission spectrum of each of the compounds A, B and D is overlapped with the absorption spectrum of the compound C used in the charge-generating layer, the above-mentioned energy transfer occurs.

As compared with Example 2 in which the compound A is used in the charge-transporting layer and the compound C is used in the charge-generating layer, the organic thin film solar cell of Example 3 in which the compound B is used in the charge-transporting layer (Compound D) and the compound C is used in the charge-generating layer has particularly excellent conversion efficiency. The reason therefor is that, by transfer of excited energy generated in the charge-transporting layer by light irradiation to the compound C of the charge-generating layer, the amount of excited energy which can be used by the charge-generating layer (compound C) is increased. This effect by the excited energy transfer can be confirmed by comparing with Example 2 where the compound A is used in the charge-transporting layer. That is, since the emission spectrum of the compound A does not overlap with the absorption spectrum of the compound C, transfer of excited energy does not occur in Example 2.

The important fact which can be understood from the results is that, improvement in conversion efficiency due to the transfer of excited energy (compare Example 2 with Example 3) is significantly small as compared with the improvement in conversion efficiency caused by the charge-transporting layer of the invention (compare Example 2 with Comparative Example 2). For essential improvement in conversion efficiency, significant effects can be obtained by noting to the charge-transporting layer rather than noting to energy transfer.

As for the electron-blocking properties of the charge-transporting layer, since the affinity level of the compound D used in Comparative Example 2 is small as compared with the compounds A and B used in Examples, it can be assumed that the cell of Comparative Example 2 has higher electron blocking properties. However, the cells of Examples have a significantly high conversion efficiency as compared with the cell of Comparative Example 2. Therefore, in order to improve the conversion efficiency essentially, significant effects can be obtained by noting to the charge-transporting layer of the invention rather than by noting to blocking of electrons.

As mentioned above, in the organic thin film solar cell of the invention, by using a compound having a carrier mobility of 1 x $10^{-9}$ $cm^2/Vs$ or more at $E_0$, the conversion efficiency is significantly improved and excellent cell properties are exhibited.

INDUSTRIAL APPLICABILITY

The organic thin film solar cell of the invention and the module can be used in a watch, a cellular phone, a mobile personal computer or the like.

Although only some exemplary embodiments and/or examples of this invention have been described in detail above, those skilled in the art will readily appreciate that many modifications are possible in the exemplary embodiments and/or examples without materially departing from the novel teachings and advantages of this invention. Accordingly, all such modifications are intended to be included within the scope of this invention.

The documents described in the specification are incorporated herein by reference in its entirety.

## Claims

1. An organic thin film solar cell comprising a cathode, a charge-generating layer and an anode being sequentially stacked, which further comprises a charge-transporting layer having a carrier mobility of $1 \times 10^{-9}$ $cm^2/Vs$ or more at an electric field intensity of 0 V/cm between the cathode and the charge-generating layer and/or between the anode and the charge-generating layer.

2. The organic thin film solar cell according to claim 1, wherein the charge-transporting layer has a function of blocking the transportation of charges which are reverse to the charges to be primarily transported by the charge-transporting layer.

3. The organic thin film solar cell according to claim 1 or 2, wherein the charge-generating layer comprises a complex.

4. The organic thin film solar cell according to claim 3, wherein the complex is a phthalocyanine complex.

5. The organic thin film solar cell according to claim 3, wherein the complex is a naphthalocyanine complex.

6. The organic thin film solar cell according to any of claims 1 to 5, wherein the charge-generating layer comprises fullerene or a fullerene derivative.

7. The organic thin film solar cell according to any of claims 1 to 6, wherein the charge-transporting layer between the cathode and the charge-generating layer has an ionization potential of 5.2 to 5.8 eV.

8. A module for an organic thin film solar cell which uses the organic thin film solar cell according to any of claims 1 to 7.

FIG.1

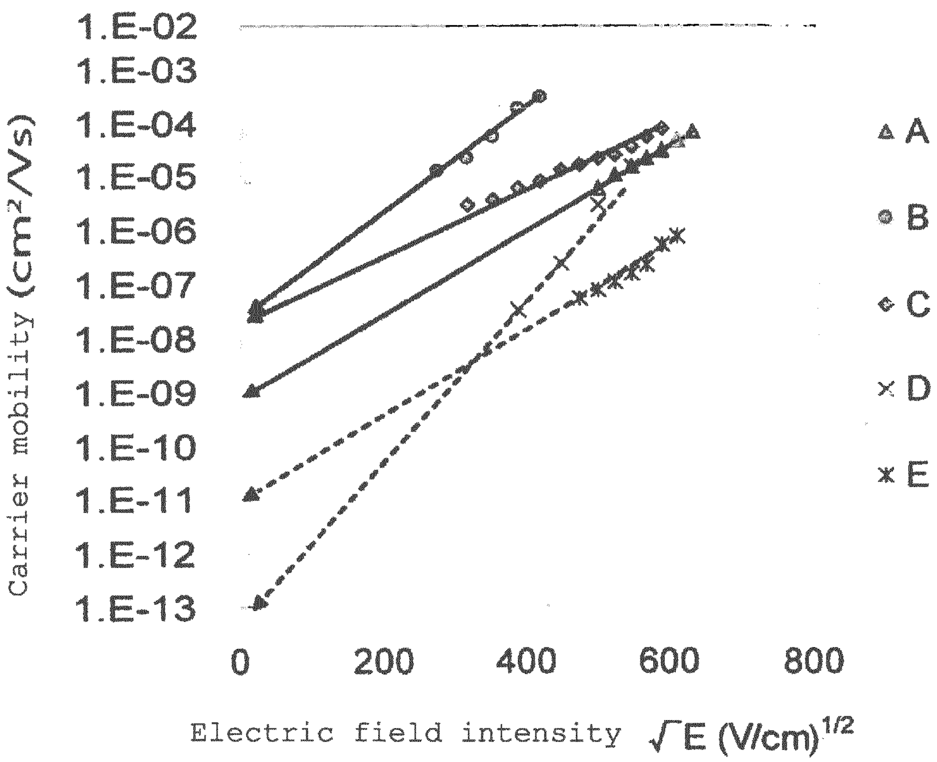
1.E-02
1.E-03
1.E-04
1.E-05
1.E-06
1.E-07
1.E-08
1.E-09
1.E-10
1.E-11
1.E-12
1.E-13
Carrier mobility (cm²/Vs)
0
200
400
600
800
Electric field intensity √E (V/cm)^1/2
A
B
C
D
E

FIG.2

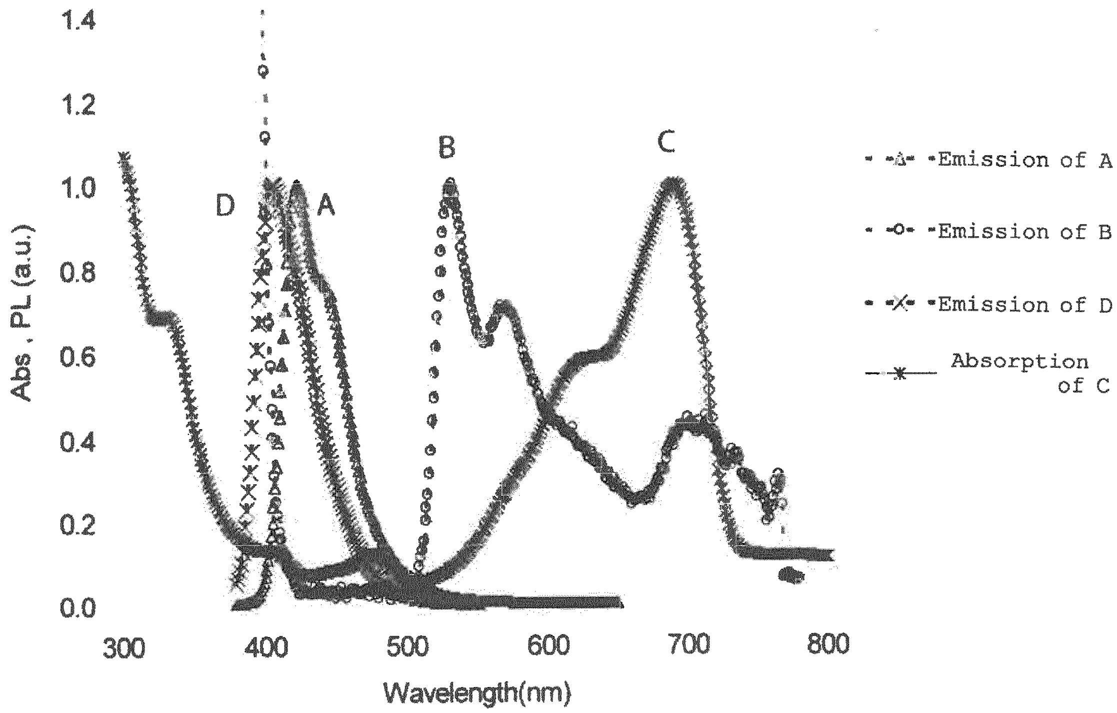
1.4
1.2
1.0
0.8
0.6
0.4
0.2
0.0
Abs , PL (a.u.)
D
A
B
C
300
400
500
600
700
800
Wavelength(nm)
Emission of A
Emission of B
Emission of D
Absorption of C

**INTERNATIONAL SEARCH REPORT**

International application No.
PCT/JP2012/002175

A. CLASSIFICATION OF SUBJECT MATTER
*H01L51/42*(2006.01)i

According to International Patent Classification (IPC) or to both national classification and IPC

B. FIELDS SEARCHED

Minimum documentation searched (classification system followed by classification symbols)
H01L51/42-51/48

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)
JSTPlus(JDreamII)

C. DOCUMENTS CONSIDERED TO BE RELEVANT

| Category* | Citation of document, with indication, where appropriate, of the relevant passages | Relevant to claim No. |
|---|---|---|
| Y | WO 2010/134432 A1 (Konica Minolta Holdings, Inc.), 25 November 2010 (25.11.2010), paragraphs [0001] to [0005], [0036], [0047] to [0067], [0088]; fig. 1 (Family: none) | 1-8 |
| Y | JP 2009-510790 A (The Trustees of Princeton University), 12 March 2009 (12.03.2009), paragraphs [0090] to [0093] & US 2007/0087449 A1 & EP 1938400 A1 & WO 2007/041413 A1 & KR 10-2008-0063798 A & CN 101313424 A | 1-8 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 26 June, 2012 (26.06.12) | 03 July, 2012 (03.07.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2007015503 A
- JP 2007134444 A
- JP 2007088033 A


### Non-patent literature cited in the description


- *PHYSICAL REVIEW B,* 2001, vol. 63, 125328